(19) **Europäisches Patentamt**
**European Patent Office**
**Office européen des brevets**

(11) **EP 2 246 316 A1**

(12) **EUROPEAN PATENT APPLICATION**
published in accordance with Art. 153(4) EPC

(43) Date of publication:
**03.11.2010 Bulletin 2010/44**

(51) Int Cl.:
***C04B 35/00*** *(2006.01)* ***H01L 35/22*** *(2006.01)*

(21) Application number: **09709545.9**

(86) International application number:
**PCT/JP2009/052596**

(22) Date of filing: **10.02.2009**

(87) International publication number:
**WO 2009/102073 (20.08.2009 Gazette 2009/34)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **14.02.2008 JP 2008032759
10.04.2008 JP 2008102179**

(71) Applicant: **Sumitomo Chemical Company, Limited
Tokyo 104-8260 (JP)**

(72) Inventor: **SADAOKA, Kazuo
Toyonaka-shi
Osaka 561-0802 (JP)**

(74) Representative: **Hart-Davis, Jason et al
Cabinet Beau de Loménie
158, rue de l'Université
75340 Paris Cedex 07 (FR)**

(54) **SINTERED BODY AND THERMOELECTRIC MATERIAL**

(57) Disclosed are a sintered body and a thermoelectric conversion material. The sintered body comprises a manganese-based oxide as a main component and the sintered body has a relative density of 90% or more and an average of the size of particles constituting the sintered body is 3 $\mu$m or less.

**Description**

TECHNICAL FIELD

The present invention relates to a sintered body and a thermoelectric conversion material. More particularly, the present invention relates to a sintered body comprising a manganese-based oxide, and to a thermoelectric conversion material.

BACKGROUND ART

Sintered bodies containing a manganese-based oxide are utilized in various fields such as magnetic materials, solid oxides for fuel cells and thermoelectric conversion materials.

A manganese-based oxide includes $CaMnO_3$. JP-A No. 2003-142742 (p. 2-3, Examples) discloses to use this as a thermoelectric conversion material and specifically discloses that starting materials are blended so as to provide a predetermined composition, calcined, pulverized, molded, and sintered in atmospheric air to yield a sintered body of a manganese-based oxide.

DISCLOSURE OF THE INVENTION

However, the sintered body obtained above has constituent particles of large size and has a problem that cracks are generated in the sintered body when applying pressure such as processing thereof, that is, mechanical strength thereof is not sufficient. The present invention has an object of providing a sintered body excellent in mechanical strength, as compared with sintered bodies of a conventional manganese-based oxide.

The present inventors have variously investigated and resultantly completed the present invention. That is, the present invention provides the following inventions.

<1> A sintered body comprising a manganese-based oxide as a main component, wherein the sintered body has a relative density of 90% or more and an average of the size of particles constituting the sintered body is 3 $\mu$m or less.

<2> The sintered body according to <1>, wherein the manganese-based oxide has a perovskite type crystal structure or a layered perovskite type crystal structure.

<3> The sintered body according to <2> further comprising an inorganic substance, wherein the inorganic substance is not the manganese-based oxide.

<4> The sintered body according to <3>, wherein the inorganic substance is one or more oxides selected from among nickel oxide, copper oxide and zinc oxide.

<5> The sintered body according to <4>, wherein the inorganic substance is copper oxide.

<6> The sintered body according to <4> or <5>, wherein the ratio of the total molar amount of M contained in the sintered body to one mol of manganese contained in the sintered body is from 0.0001 to 1, wherein M represents one or more members selected from the group consisting of nickel, copper and zinc.

<7> The sintered body according to <6>, wherein M represents copper and the ratio of the total molar amount of M contained in the sintered body to one mol of manganese contained in the sintered body is from 0.001 to 0.05.

<8> The sintered body according to any one of <1> to <7>, wherein $D_{90}/D_{10}$ is from 1.0 to 2.0 where $D_{10}$ represents the size of a particle that attains a 10% cumulation measured from the finest side and $D_{90}$ represents the size of a particle that attains a 90% cumulation measured from the finest side in the cumulative particle size distribution of sizes of particles constituting the sintered body.

<9> A thermoelectric conversion material composed of the sintered body according to any one of <1> to <8>.

<10> A thermoelectric conversion device having the thermoelectric conversion material according to <9>.

MODE FOR CARRYING OUT THE INVENTION

The sintered body of the present invention comprises a manganese-based oxide as a main component, wherein the sintered body has a relative density of 90% or more and an average of the size of particles constituting the sintered body is 3 $\mu$m or less. The manganese-based oxide means an oxide containing manganese, and the manganese-based oxide includes an oxide represented by $AMnO_3$ (here, A represents one or more elements selected from the group consisting of Ca, Sr, Ba, La, Y and lanthanoid), $Ca_{n+1}Mn_nO_{3n+1}$ (here, n represents an integer of from 1 to 10), $CaMn_7O_{12}$, $Mn_3O_4$, $MnO_2$ or $CuMnO_2$, and it is preferable that the manganese-based oxide have a perovskite type crystal structure or a layered perovskite type crystal structure for further enhancing a thermoelectric converting property as a thermoelectric conversion material. The manganese-based oxide is preferably a calcium manganese oxide further containing calcium. In the present invention, "comprising a manganese-based oxide as a main component" means that the amount of a manganese-based oxide in a sintered body is 50 mol% or more. This can be measured by powder X-ray diffractometry, composition analysis and the like of a sintered body.

The manganese-based oxide having a perovskite type crystal structure specifically includes an oxide represented by $CaMnO_3$ (here, Ca and/or Mn may be partially substituted by heterogeneous elements), and the heterogeneous element for partially substituting Ca includes one or more elements selected from among Mg, Sr, Ba, Sc, Y, La, Ce, Pr, Nd, Sm, Eu, Gd, Tb, Dy, Ho, Er, Tm, Yb, Lu, Bi, Sn, In and Pb, and the said one or more elements preferably contain one or more elements selected from among Mg, Sr and Ba. The heterogeneous element for partially substituting Mn includes one or more elements selected from among V, Ru, Nb, Mo, W and Ta. When Ca and/or Mn of an oxide represented by $CaMnO_3$ is partially substituted by heterogeneous elements, as described above, a thermoelectric converting property in the case of use of the sintered body of the present invention as a thermoelectric conversion material may be further enhanced in some cases.

The manganese-based oxide having a layered perovskite type crystal structure specifically includes an oxide represented by the formula (1).

$$Ca_{n+1}Mn_nO_{3n+1} \qquad (1)$$

(here, n represents an integer of from 1 to 10, and Ca and/or Mn may be partially substituted by heterogeneous elements).

The heterogeneous element for partially substituting Ca in the formula (1) includes one or more elements selected from among Mg, Sr, Ba, Sc, Y, La, Ce, Pr, Nd, Sm, Eu, Gd, Tb, Dy, Ho, Er, Tm, Yb, Lu, Bi, Sn, In and Pb, and the one or more elements preferably contain one or more elements selected from among Mg, Sr and Ba. The heterogeneous element for partially substituting Mn includes one or more elements selected from among V, Ru, Nb, Mo, W and Ta. When Ca and/or Mn of an oxide represented by the formula (1) is partially substituted by heterogeneous elements, as described above, a thermoelectric converting property in the case of use of the sintered body of the present invention as a thermoelectric conversion material may be further enhanced in some cases.

The sintered body can further comprise an inorganic substance, wherein the inorganic substance is not the manganese-based oxide, thereby further enhancing the effect of the present invention. The inorganic substance is selected appropriately depending on the manganese-based oxide to be used. The inorganic substance includes a non-oxide material typified by a carbide such as silicon carbide, titanium carbide and boron carbide and a nitride such as silicon nitride and boron nitride, and an oxide-based material. The inorganic substance preferably contains an oxide-based material, and is more preferably an oxide-based material. The oxide-based material includes a mixed oxide and a simple oxide, and for further enhancing the effect of the present invention, a simple oxide is preferable. The simple oxide includes titanium oxide, cobalt oxide, nickel oxide, copper oxide, zinc oxide, zirconium oxide, niobium oxide, molybdenum oxide, aluminum oxide, silicon oxide, gallium oxide, indium oxide and tin oxide. An oxynitride is classified in the oxide-based material.

It is preferable that the inorganic substance contained in a sintered body be one or more oxides selected from among nickel oxide, copper oxide and zinc oxide. Copper oxide is more preferable. These inorganic substances are particularly suitable when the manganese-based oxide has a perovskite type crystal structure or a layered perovskite type crystal structure.

When the manganese-based oxide has a perovskite type crystal structure or a layered perovskite type crystal structure and when the sintered body further contains an inorganic substance which is one or more oxides selected from among nickel oxide, copper oxide and zinc oxide, it is preferable that the ratio of the total molar amount of M contained in the sintered body to one mol of manganese contained in the sintered body is from 0.0001 to 1, wherein M represents one or more members selected from the group consisting of nickel, copper and zinc. When the sintered body contains copper oxide, the above-described M represents copper, and the ratio of the total molar amount of M (copper) contained in the sintered body to one mol of manganese contained in the sintered body is preferably from 0.0001 to 0.25, more preferably from 0.001 to 0.11, further more preferably from 0.001 to 0.05. When the sintered body contains nickel oxide, the above-described M represents nickel, and the ratio of the total molar amount of M (nickel) contained in the sintered body to one mol of manganese contained in the sintered body is preferably from 0.25 to 1, more preferably from 0.33 to 0.66. When the sintered body contains zinc oxide, the above-described M represents zinc, and the ratio of the total molar amount of M (zinc) contained in the sintered body to one mol of manganese contained in the sintered body is preferably from 0.25 to 1, more preferably from 0.33 to 0.66.

The relative density of the sintered body is 90% or more, preferably 95% or more. The sintered body can be used in a shape suitable for each application, such as plate, circular cylinder, and rectangular cylinder. The relative density is determined by the following formula where the formula weight of one mol of a manganese-based oxide in a sintered body is represented by $\alpha$, the theoretical density of a manganese-based oxide is represented by $A(g/cm^3)$, the formula weight of one mol of an inorganic substance is represented by $\beta$, the theoretical density of an inorganic substance is represented by $B (g/cm^3)$, the actually measured density of a sintered body is represented by $C (g/cm^3)$ and the ratio of an inorganic substance to a sintered body is represented by x (mol%).

$$\text{Relative density (\%)} = C/[\{\alpha \times (100-x) + \beta \times x\}/\{\alpha \times (100-x)/A + \beta \times x/B\}] \times 100$$

In the case of containing no inorganic substance, the following formula is used.

$$\text{Relative density (\%)} = C/A \times 100$$

The average of the size of particles constituting a sintered body is 3 $\mu$m or less. The average of the size of particles is preferably 2 $\mu$m or less, and in this case, the mechanical strength of a sintered body can be further enhanced. The smaller average of the size of the particles is more preferable. The size of particles constituting a sintered body can be measured by observing the surface of a sintered body with a scanning electron microscope (SEM). Specifically, observation of a reflected electron image with a scanning electron microscope (SEM) is performed on the surface obtained by mirror-polishing of an arbitrary surface of a sintered body, 100 particles constituting a sintered body are arbitrarily picked out of the resultant observed image, and the area and the equivalent circle diameter corresponding to the area of each of the 100 particles are measured with an image treatment means, and the average thereof is calculated, thus, the average of the size of particles constituting a sintered body can be determined.

$D_{90}/D_{10}$ is preferably from 1.0 to 2.0 where $D_{10}$ represents the size of a particle that attains a 10% cumulation measured from the finest side and $D_{90}$ represents the size of a particle that attains a 90% cumulation measured from the finest side in the cumulative particle size distribution of sizes of particles constituting a sintered body. This $D_{90}/D_{10}$ is advantageously nearer to 1.0. By adjusting the $D_{90}/D_{10}$ in such a range, the mechanical strength of a sintered body can be further enhanced. Here, the cumulative particle size distribution means a relationship between particle size (equivalent circle diameter) and cumulative value (particle number). More specifically, observation of a reflected electron image with a scanning electron microscope (SEM) is performed on the surface obtained by mirror-polishing of an arbitrary surface of a sintered body, 100 particles constituting a sintered body are arbitrarily picked out of the resultant observed image, and the area and the equivalent circle diameter corresponding to the area of each of the 100 particles are measured with an image treatment means, and using the resultant data of sizes of the 100 particles, 100 data are arranged sequentially from the minimum size datum, and the size of the 10-th particle from the finest particle side is represented by $D_{10}$ and the size of the 90-th particle from the finest particle side is represented by $D_{90}$, thus, the value of $D_{90}/D_{10}$ is determined.

Next, a method of producing a sintered body of the present invention will be described.

First, the manganese-based oxide can be produced by calcining a metal compound mixture which can become the manganese-based oxide by calcination. Specifically, compounds containing constituent metal elements are weighed and mixed so as to provide a predetermined composition, and the resultant metal compound mixture is calcined, whereby the manganese-based oxide can be produced.

As the above-described compound containing metal elements, for example, an oxide is used, alternatively, a compound capable of becoming a oxide when decomposed and/or oxidized at high temperatures, such as a hydroxide, a carbonate, a nitrate, a halide, a sulfate, and an organic acid salt is used. Instead of the compound, a metal containing the above-described metal elements may be used. In the case of use of $CaMnO_3$ as the manganese-based oxide, constituent metal elements are Ca and Mn, and the compound containing Ca includes a carbonate, a sulfate, a hydroxide and the like, and a carbonate is preferably used. The compound containing Mn includes manganese monoxide, manganese dioxide, dimanganese trioxide, trimanganese tetraoxide, manganese nitrate, manganese acetate and the like, and manganese dioxide is preferably used.

Mixing of the above-described compounds containing metal elements may be carried out by either a dry mixing method or a wet mixing method, and a method capable of uniformly mixing compounds containing metal elements is preferably carried out, and in this case, examples of the mixing apparatus include apparatuses such as a ball mill, a V-shaped mixer, a vibration mill, an attritor, a dino mill and a dynamic mill.

In calcination of a metal compound mixture, a calcining temperature and a calcining atmosphere may be appropriately set so as to yield the intended manganese-based oxide. The resultant manganese-based oxide can be molded and sintered to yield a sintered body. In the present invention, in the case of containing no inorganic substance, it is necessary to carry out a pressure sintering such as a hot press and a pulse current sintering.

Next, the method of producing a sintered body of the present invention will be explained, referring to a case of use of an inorganic substance as an example. In this case, a sintered body can be produced by molding a mixture of a manganese-based oxide and an inorganic substance (here, the inorganic substance is not the menganese-based oxide) to yield a molded body, and sintering the molded body by heating up to the sintering temperature in an oxidizing atmosphere. This atmosphere preferably includes an air atmosphere or an atmosphere containing oxygen in an amount of 20 vol% or more. The atmosphere containing oxygen in an amount of 20 vol% or more includes an oxygen atmosphere, and a mixed gas atmosphere of oxygen-inert gas (oxygen-nitrogen, oxygen-argon, and the like).

A sintered body of the present invention can also be produced by a method in which the manganese-based oxide obtained as described above is used, a mixture of the manganese-based oxide and an inorganic substance (here, the inorganic substance is not the manganese-based oxide) is thermally treated (here, the thermal treatment temperature is a temperature lower than the sintering temperature) in the oxidizing atmosphere as described above, the resultant powder is molded to yield a molded body, and the molded body is sintered in an oxidizing atmosphere. By this, the uniformity of the composition of the sintered body obtained in sintering and the uniformity of the structure of the sintered body can be improved, and the deformation of the sintered body can be suppressed, in some cases. As the sintering atmosphere, an inert atmosphere may also be substituted for the above-described oxidizing atmosphere. The inert atmosphere includes atmospheres composed of an inert gas such as nitrogen, argon and the like. The inert atmosphere may contain oxygen in an approximate amount not generating an oxidizing atmosphere (for example, the oxygen concentration is less than about 20 vol%). It is also possible, after sintering in such an inert atmosphere, to perform annealing in an oxidizing atmosphere, thereby controlling the oxygen amount in a sintered body. Moreover, the resultant sintered body may be pulverized, and sintering may be carried out again using the pulverized substance.

Mixing of a manganese-based oxide and an inorganic substance may be carried out by either a dry mixing method or a wet mixing method, and a method capable of performing more uniform mixing is preferable, and in this case, examples of the mixing apparatus include apparatuses such as a ball mill, a V-shaped mixer, a vibration mill, an attritor, a dino mill and a dynamic mill. Further, the mixing may be accompanied by pulverization.

The above-described molded body may be produced so as to give a shape suitable as a thermoelectric converting device such as a plate shape, a rectangular cylinder shape and a circular cylinder shape. The molding method can be carried out, for example, by a uniaxial press, a cold isostatic press (CIP), a mechanical press, a hot press and a hot isostatic press (HIP). The molded body may contain a binder, a dispersant, a releasing agent and the like.

The above-described mixture of a manganese-based oxide and an inorganic substance may also be produced by calcining a mixture of a metal compound mixture and an inorganic substance. Namely, a sintered body of the present invention can also be produced by a method in which an inorganic substance and a metal compound mixture which can become a manganese-based oxide by calcination are mixed, and the resultant mixture is, for example, heated up to a calcining temperature (here, the calcining temperature is lower than the sintering temperature) in an oxidizing atmosphere and calcined to yield powder which is then molded to yield a molded body, and the molded body is heated up to the sintering temperature in an oxidizing atmosphere and sintered. By this, the uniformity of the composition of the sintered body obtained in sintering and the uniformity of the structure of the sintered body can be improved, the deformation of the sintered body can be suppressed, and the mechanical strength of the sintered body can be further enhanced, in some cases. It is also possible that, instead of the inorganic substance to be used in production, an inorganic raw material which can become an inorganic substance by calcination is used, and an inorganic substance is obtained by the subsequent calcination.

In the above-described methods, thermal treatment conditions such as a thermal treatment temperature, a thermal treatment atmosphere and a thermal treatment temperature retention time, and calcination conditions such as a calcining temperature, a calcining atmosphere and a calcining temperature retention time, may be appropriately set depending on the kind of a manganese-based oxide and an inorganic substance.

Next, an explanation will be made on a production method of a sintered body of the present invention in which the preferable combination of manganese-based oxide/inorganic substance is a combination of manganese-based oxide having a perovskite type crystal structure or a layered perovskite type crystal structure/CuO, particularly, for a typical case in which the mangenese-based oxide is $CaMnO_3$.

When the combination of manganese-based oxide/inorganic substance is $CaMnO_3$/CuO, a sintered body of the present invention can be produced by molding a mixture of $CaMnO_3$ and CuO to yield a molded body, and sintering the molded body by heating up to a sintering temperature within the range of from 800°C to 1200°C. The retention time of the sintering temperature is 0 to 48 hours. When the sintering temperature is less than 800°C, sintering is difficult in some cases, and when the sintering temperature is over 1200°C, a sintered body is not formed easily in some cases because of elution of CuO. The sintering temperature is preferably within the range of from 900°C to 1200°C, further preferably within the range of from 950°C to 1100°C. The sintering atmosphere is preferably an oxidizing atmosphere. It is also possible to control the oxygen amount in a manganese-based oxide, by changing the oxygen concentration. It may also be permissible, after sintering in an inert atmosphere, to control the oxygen amount contained in a sintered body by performing annealing in an oxidizing atmosphere.

The above-described mixture of $CaMnO_3$ and CuO is preferably produced by calcining a mixture of CuO and a metal compound mixture which can become $CaMnO_3$ by calcination. In this case, the calcination conditions include calcination conditions of keeping at a calcining temperature of from 600°C to 1200°C in an oxidizing atmosphere for 0 to 24 hours.

The manganese-based oxide can be produced by the above-described method. Mentioned as other production methods are a method having a co-precipitation step, a method having a hydrothermal step, a method having a dry up step, a method having a sol gel atep, and the like.

The relative density of the sintered body and the average of the size of particles constituting the sintered body cen be adjusted by, for example, the particle size of a metal compound mixture, the particle size of a mixture of a manganese-based oxide and an inorganic substance, the particle size of a powder obtained by calcining the mixture, the molding pressure in producing a molded body, the sintering temperature and the sintering time, in the above-described production.

Further, it may also be permissible that a sintered body obtained as described above is pulverized, and sintering as described above is carried out again using the pulverized substance.

The sintered body obtained as described above is excellent in mechanical strength. It is excellent also in thermal shock resistance, and moreover, as a thermoelectric conversion material, its thermoelectric converting property is not deteriorated, thus, a thermoelectric conversion material composed of this sintered body is very useful for a thermoelectric conversion device. For a thermoelectric conversion device, a known technology as disclosed in, for example, JP-A No. 5-315657 may be used. In a thermoelectric converting device, a p-type thermoelectric conversion material and an n-type thermoelectric conversion material may be used in combination, and it may also be permissible that a thermoelectric conversion material of the present invention is used in any one of a p-type thermoelectric conversion material and an n-type thermoelectric conversion material and a known technology is used in another material.

The efficiency of converting thermal energy into electric energy of a thermoelectric conversion material (hereinafter, referred to as "energy conversion efficiency" in some cases) depends on the value (Z) of the performance index of a thermoelectric conversion material. The value (Z) of the performance index is a value determined according to the following formula (2) using the value ($\alpha$) of the Seebeck coefficient, the value ($\sigma$) of the electric conductivity and the value ($\kappa$) of the thermal conductivity of a thermoelectric conversion material. A thermoelectric conversion material having larger value (Z) of the performance index is said to be a thermoelectric converting device excellent in energy conversion efficiency. Particularly, $\alpha^2 \times \sigma$ in the formula (2) is called power factor (PF), and a thermoelectric conversion material having larger its value is said to be thermoelectric converting device excellent in output per unit temperature.

$$Z = \alpha^2 \times \sigma / \kappa \quad (2)$$

Here, the unit of Z is 1/K, the units of $\alpha$ is V/K, the unit of $\sigma$ is S/m and the unit of $\kappa$ is W/(m·K).

EXAMPLES

The present invention will be illustrated further in detail by examples below. For evaluation of the property and structure of a thermoelectric conversion material, methods shown below were used.

1. Electric conductivity ($\sigma$)

A sintered body specimen was processed into a rectangular cylinder shape, a platinum line was bonded thereto with a silver paste, and the value ($\sigma$) of the electric conductivity was measured by a direct current four-terminal method. The measurement was carried out while changing the temperature in the range from room temperature to 1073 K in a nitrogen gas flow. The unit of $\sigma$ was S/m.

2. Seebeck coefficient ($\alpha$)

A R thermo couple (composed of platinum-rhodium line and platinum line) was, with a silver paste, bonded on the both end surfaces of a sintered body specimen processed into the same shape as in measurement of electric conductivity, and the temperatures of the both end surfaces of the sintered body specimen and thermoelectromotive forces were measured. The measurement was carried out while changing the temperature in the range from room temperature to 1073 K in a nitrogen gas flow. A glass tube in which air was flowing was allowed to contact the one end surface of the sintered body specimen to make a low temperature part, the temperatures of the both end surfaces of the sintered body specimen were measured by a R thermo couple, and simultaneously, the thermoelectromotive force ($\Delta V$) generated between the both end surfaces of the sintered body specimen was measured by a platinum line of the R thermo couple. The temperature difference ($\Delta T$) between the both ends of the sintered body specimen was controlled in the range of 1 to 10°C by controlling the flow rate of air flowing in the glass tube, and the value ($\alpha$) of Seebeck coefficient

was determined from the inclinations of $\Delta T$ and $\Delta V$. The unit of $\alpha$ was $\mu V/K$.

3. Power factor (PF)

The value of PF was determined according to the following formula from the above-described values of $\sigma$, $\alpha$.

$$PF = \alpha^2 \times \sigma$$

Here, the unit of PF is $W/(m \cdot K^2)$, the unit of $\alpha$ is V/K, and the unit of $\sigma$ is S/m.

4. Structure analysis

The crystal structure of thermally treated articles and sintered body specimens was analyzed by a powder X-ray diffraction method using $CuK\alpha$ as a radiation source, using an X-ray diffractometer RINT2500TTR type manufactured by Rigaku Corporation.

5. Bending strength

A rod-shaped sintered body having a width (w) of $4\pm1$ mm, a thickness (t) of $3\pm1$ mn and a length of 36 mm or more was fabricated, and a three point bending test was carried out using SHIKIBU manufactured by Shimadzu Corp. A distance (L) between supporting points was 30 mm, and the cross head speed was 0.5 mm/min.
Bending strength ($\delta$) was determined according to the following formula.

$$\delta = 3PL/2wt^2$$

(P represents maximum load (N) in breaking of a specimen piece, and the unit of $\delta$ is N/ mm$^2$).
Seven or more samples were measured for each specimen and data was determined, and the average value ($\delta_{ave}$) was determined excluding the maximum data and the minimum data.

6. Size of particle of sintered body

The average of the size of particles constituting a sintered body was determined by a method in which observation of a reflected electron image with a scanning electron microscope (SEM) was performed on the surface obtained by mirror-polishing of an arbitrary surface of a sintered body, 100 particles constituting a sintered body were arbitrarily picked out of the resultant observed image, and the areas and the equivalent circle diameter corresponding to the area of each of the 100 particles were measured with an image treatment means, and the average thereof were calculated. The scanning electron microscope used for obtaining an observed image was Hitachi Ultra-high resolution field emission scanning electron microscope (type S-4800, manufactured by Hitachi High-Technologies Corporation), and the observation conditions included an acceleration voltage of 5 kV, a probe current value of $1\times10^{-10}$A to $1\times10^{-11}$A, a YAG reflected electron detector, and an operating distance of 8.5 mm.

Example 1

$CaCO_3$ (manufactured by Ube Material Industries, CS3N-A (trade name)) of 8.577 g, $MnO_2$ (manufactured by Kojundo Chemical Laboratory) of 7.852 g, $MoO_3$ (manufactured by Kojundo Chemical Laboratory) of 0.247 g and NiO (manufactured by Kojundo Chemical Laboratory) of 6.403 g were weighed out (the ratio of the total molar amount of M to one mol of manganese was 0.67), and mixed for 20 hours by a wet ball mill using zirconia balls, and calcined by keeping at 900°C for 10 hours in air, the resultant calcined substance was pulverized for 20 hours by a wet ball mill using zirconia balls, and molded into a rod shape by a uniaxial press (molding pressure: 500 kg/cm$^2$), and the resultant molded body was sintered by keeping at 1300°C for 10 hours air to yield Sintered body 1. Powder X-ray diffractometry revealed that Sintered body 1 had the same crystal structure as a perovskite type crystal of $CaMnO_3$ and the crystal structure of NiO. Based on them, it was found that the manganese-based oxide was a main component in Sintered body 1.
Regarding the property of Sintered body 1, the Seebeck coefficient measured at 673 K was -137 ($\mu V/K$), the electric conductivity measured at 673 K was $5.3\times10^3$ (S/m), and the power factor (PF) was determined to be $1.0\times10^{-4}$

$(W/mK^2)$. The average value ($\delta_{ave}$) of the bending strength in a three point bending test of Sintered body 1 was 510, the average value of Sintered body 2 in Comparative Example 1 being 100. The average of the size of particles of $CaMh_{0.98}Mo_{0.02}O_3$ constituting Sintered body 1 was 2.0 $\mu$m, and the $D_{90}/D_{10}$ thereof was 2.0. The relative density of Sintered body 1 was 97.9%.

Comparative Example 1

Sintered body 2 was fabricated in the same manner as in Example 1 excepting that the NiO was not used (the ratio of the total molar amount of M to one mol of manganese was 0). Powder X-ray diffractometry revealed that Sintered body 2 had the same crystal structure as a perovskite type crystal of $CaMnO_3$.

Regarding the property of Sintered body 2, the Seebeck coefficient measured at 673 K was -139 ($\mu$V/K), the electric conductivity measured at 673 K was $4.9 \times 10^3$ (S/m), and the power factor was determined to be $9.5 \times 10^{-5}$ $(W/mK^2)$. The average value ($\delta_{ave}$) of the bending strength in a three point bending test of Sintered bods 2 was 100. The average of the size of particles of $CaMn_{0.98}MO_{0.02}O_3$ constituting Sintered body 2 was 3.8 $\mu$m, and the $D_{90}/D_{10}$ thereof was 2.1. The relative density of Sintered body 2 was 96.0%.

Example 2

A molded body was fabricated in the same manner as in Example 1 excepting that a calcined substance was obtained using copper oxide (CuO, manufactured by Kojundo Chemical Laboratory) of 4.545 g (the ratio of the total molar amount of M to one mol of manganese was 0.67) instead of nickel oxide, and the resultant molded body was sintered by keeping at 1050°C for 10 hours in air to fabricate Sintered body 3. Powder X-ray diffractometry revealed that Sintered body 3 had the same crystal structure as a perovskite type crystal of $CaMnO_3$ and the crystal structure of CuO. Based on them, it was found that the manganese-based oxide was a main component in Sintered body 3.

Regarding the property of Sintered body 3, the Seebeck coefficient measured at 673 K was -120 ($\mu$V/K), the electric conductivity measured at 673 K was $7.7 \times 10^3$ (S/m), and the power factor was determined to be $1.1 \times 10^{-4}$ $(W/mK^2)$. The average value ($\delta_{ave}$) of the bending strength in a three point bending test of Sintered body 3 was 624, the average value of Sintered body 2 in Comparative Example 1 being 100. The average of the size of particles of $CaMn_{0.98}MO_{0.02}O_3$ constituting Sintered body 3 was 1.4 $\mu$m, and the $D_{90}/D_{10}$ thereof ways 1.7. The relative density of Sintered body 3 was 99.0%.

Example 3

Sintered body 4 was fabricated in the same manner as in Example 2 excepting that the use amount of copper oxide (CuO) was 0.757 g (the ratio of the total molar amount of M to one mol of manganese was 0.11). Sintered body 4 was subjected to powder X-ray diffractometry, to find that Sintered body 4 had the same crystal structure as a perovskite type crystal of $CaMnO_3$, to detect no other crystal structures, and to find that the manganese-based oxide was a main component.

Regarding the property of Sintered body 4, the Seebeck coefficient measured at 673 K was -146 ($\mu$V/K), the electric conductivity measured at 673 K was $8.2 \times 10^3$ (S/m), and the power factor was determined to be $1.7 \times 10^{-4}$ $(W/mK^2)$. The average value ($\delta_{ave}$) of the bending strength in a three point bending test of Sintered body 4 was 576, the average value of Sintered body 2 in Comparative Example 1 being 100. The average of the size of particles of $CaMn_{0.98}MO_{0.02}O_3$ constituting Sintered body 4 was 1.9 $\mu$m, and the $D_{90}/D_{10}$ thereof was 1.9. The relative density of Sintered body 4 was 96.7%.

Example 4

Sintered body 5 was fabricated in the same manner as in Example 2 excepting that the use amount of copper oxide (CuO) was 0.359 g (the ratio of the total molar amount of M to one mol of manganese was 0.05). Sintered body 5 was subjected to powder X-ray diffractometry, to find that Sintered body 5 had the same crystal structure as a perovskite type crystal of $CaMnO_3$, to detect no other crystal structures, and to find that the manganese-based oxide was a main component.

Regarding the property of Sintered body 5, the Seebeck coefficient measured at 673 K was -150 ($\mu$V/K), the electric conductivity measured at 673 K was $1.1 \times 10^4$ (S/m), and the power factor was determined to be $2.5 \times 10^{-4}$ $(W/mK^2)$. The average value ($\delta_{ave}$) of the bending strength in a three point bending test of Sintered body 5 was 583, the average value of Sintered body 2 in Comparative Example 1 being 100. The average of the size of particles of $CaMn_{0.98}Mo_{0.02}O_3$ constituting Sintered body 5 was 1.6 $\mu$m, and the $D_{90}/D_{10}$ thereof was 2.0. The relative density of Sintered body 5 was 97.4%.

Example 5

A molded body was fabricated in the same manner as in Example 2 excepting that a calcined substance was obtained in the same manner as in Example 2 excepting that the use amount of copper oxide (CuO) was 0.069 g (the ratio of the total molar amount of M to one mol of manganese was 0.01), the molded body was further subjected to CIP molding (molding pressure: 1000 kg/cm$^2$), then, the resultant molded body was sintered by keeping at 1050°C for 10 hours in air to fabricate Sintered body 6. Sintered body 6 was subjected to powder X-ray diffractometry, to find that Sintered body 6 had the same crystal structure as a perovskite type crystal of $CaMnO_3$, to detect no other crystal structures, and to find that the manganese-based oxide was a main component.

Regarding the property of Sintered body 6, the Seebeck coefficient measured at 673 K was -153 ($\mu$V/K), the electric conductivity measured at 673 K was $1.0 \times 10^4$ (S/m), and the power factor was determined to be $2.5 \times 10^{-4}$ (W/mK$^2$). The average value ($\delta_{ave}$) of the bending strength in a three point bending test of Sintered body 6 was 845, the average value of Sintered body 2 in Comparative Example 1 being 100. The particle size of $CaMn_{0.98}MO_{0.02}O_3$ constituting the sintered body was 1.6 $\mu$m, and the $D_{90}/D_{10}$ thereof was 1.8. The relative density of Sintered body 6 was 95.0%.

INDUSTRIAL APPLICABILITY

According to the present invention, a sintered body excellent in mechanical strength as compared with conventional manganese-based oxide sintered bodies can be provided. The sintered body of the present invention is excellent also in thermal shock resistance, and further, as a thermoelectric conversion material, its thermoelectric converting property is not deteriorated as compared with conventional materials, thus, a thermoelectric converting device having a thermoelectric conversion material composed of this sintered body can be suitably used for thermoelectric converting electric generation utilizing waste heat of factories, waste heat of incinerators, waste heat of factory furnaces, waste heat of automobiles, underground heat, solar heat and the like, and can also be used for precise temperature controlling apparatuses for laser diodes and the like, air conditioning equipments, refrigerators and the like. The sintered body of the present invention can be used also for solid oxides for fuel cells, magnetic materials, and the like, in addition to thermoelectric conversion materials.

**Claims**

1.  A sintered body comprising a manganese-based oxide as a main component, wherein the sintered body has a relative density of 90% or more and an average of the size of particles constituting the sintered body is 3 $\mu$m or less.

2.  The sintered body according to Claim 1, wherein the manganese-based oxide has a perovskite type crystal structure or a layered perovskite type crystal structure.

3.  The sintered body according to Claim 2 further comprising an inorganic substance, wherein the inorganic substance is not the manganese-based oxide.

4.  The sintered body according to Claim 3, wherein the inorganic substance is one or more oxides selected from among nickel oxide, copper oxide and zinc oxide.

5.  The sintered body according to Clam 4, wherein the inorganic substance is copper oxide.

6.  The sintered body according to Claim 4 or 5, wherein the ratio of the total molar amount of M contained in the sintered body to one mol of manganese contained in the sintered body is from 0.0001 to 1, wherein M represents one or more members selected from the group consisting of nickel, copper and zinc.

7.  The sintered body according to Claim 6, wherein M represents copper and the ratio of the total molar amount of M contained in the sintered body to one mol of manganese contained in the sintered body is from 0.001 to 0.05.

8.  The sintered body according to any one of Claims 1 to 7, wherein $D_{90}/D_{10}$ is from 1. 0 to 2.0 where $D_{10}$ represents the size of a particle that attains a 10% cumulation measured from the finest side and $D_{90}$ represents the size of a particle that attains a 90% cumulation measured from the finest side in the cumulative particle size distribution of sizes of particles constituting the sintered body.

9.  A thermoelectric conversion material composed of the sintered body according to any one of Claims 1 to 8.

**10.** A thermoelectric conversion device having the thermoelectric conversion material according to Claim 9.

**EP 2 246 316 A1**

## INTERNATIONAL SEARCH REPORT

| International application No. |
| --- |
| PCT/JP2009/052596 |

A. CLASSIFICATION OF SUBJECT MATTER
*C04B35/00(2006.01)i, H01L35/22(2006.01)i*

According to International Patent Classification (IPC) or to both national classification and IPC

B. FIELDS SEARCHED

Minimum documentation searched (classification system followed by classification symbols)
C04B35/00, H01L35/22

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| Y | JP 2003-142742 A (Toyota Central Research and Development Laboratories, Inc.), 16 May, 2003 (16.05.03), Claims; Par. Nos. [0031], [0059] (Family: none) | 1-10 |
| Y | JP 2007-335504 A (Sumitomo Chemical Co., Ltd.), 27 December, 2007 (27.12.07), Claims; Par. Nos. [0014], [0027] (Family: none) | 1-10 |
| Y | JP 2005-51103 A (Japan Science and Technology Agency), 24 February, 2005 (24.02.05), Claims; example 2; Par. No. [0030] (Family: none) | 3-7 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 09 April, 2009 (09.04.09) | 21 April, 2009 (21.04.09) |

| Name and mailing address of the ISA/ Japanese Patent Office | Authorized officer |
| --- | --- |
| Facsimile No. | Telephone No. |

Form PCT/ISA/210 (second sheet) (April 2007)

**11**

**INTERNATIONAL SEARCH REPORT**

International application No.

PCT/JP2009/052596

| C (Continuation). DOCUMENTS CONSIDERED TO BE RELEVANT |||
|---|---|---|
| Category* | Citation of document, with indication, where appropriate, of the relevant passages | Relevant to claim No. |
| Y | JP 2006-21990 A (Toshiba Ceramics Co., Ltd.), 26 January, 2006 (26.01.06), Claims; Par. Nos. [0015], [0018] (Family: none) | 8 |

Form PCT/ISA/210 (continuation of second sheet) (April 2007)

EP 2 246 316 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003142742 A

- JP 5315657 A